Europäisches Patentamt

European Patent Office

Office européen des brevets

(19)

(11) Veröffentlichungsnummer: **0 166 161**
A2

# (12) EUROPÄISCHE PATENTANMELDUNG

(21) Anmeldenummer: 85105974.1

(22) Anmeldetag: 15.05.85

(51) Int. Cl.⁴: **G 04 F 1/00,** H 03 K 3/282, H 03 K 3/017

(30) Priorität: 29.06.84 DE 3424002

(43) Veröffentlichungstag der Anmeldung: 02.01.86 Patentblatt 86/1

(84) Benannte Vertragsstaaten: **DE FR GB IT**

(71) Anmelder: **ROBERT BOSCH GMBH, Postfach 50, D-7000 Stuttgart 1 (DE)**

(72) Erfinder: **Günther, Uwe, Dipl.-Ing., Hagstrasse 38, D-7031 Nufringen (DE)**
Erfinder: **Kalkhof, Bernd, Dipl.-Ing., Am Rosenbach 10, D-7410 Reutlingen 28 (DE)**
Erfinder: **Nagel, Karl, Grundstrasse 24, D-7413 Gomaringen (DE)**

(54) **Integrierte elektrische Schaltungsanordnung zur Festlegung von Zeiten.**

(57) Es wird eine integrierte elektrische Schaltungsanordnung zur Festlegung von Zeiten, ein sogenanntes Timer-IC, vorgeschlagen, wobei eine Zeitkonstante durch eine Kapazität festgelegt wird. Diese Kapazität ist in die elektrische Schaltung so integriert, daß die Zeitkonstante durch einen steuerbaren Ladestrom der Kapazität gesteuert wird. Dabei ist der Ladestrom der Kapazität um einen wählbaren Faktor heruntergesetzt. Die so festgelegte integrierte Zeitkonstante kann dazu verwendet werden, die Frequenz eines vollständig integrierten Multivibrators festzulegen, wobei der Multivibrator niedrige Frequenzen erreichen kann, die bisher nur mit externen Kapazitäten erreicht wurden.

R. 19474

18.6.1984 Ko/Pi

0166161

ROBERT BOSCH GMBH, 7000 STUTTGART 1

Integrierte elektrische Schaltungsanordnung zur Festlegung von Zeiten

Stand der Technik

Die Erfindung geht aus von einer integrierten elektrischen Schaltungsanordnung zur Festlegung von Zeiten nach der Gattung des Hauptanspruches.

Von der Firma Texas Instruments ist bereits eine integrierte elektrische Schaltungsanordnung zur Festlegung von Zeiten mit der Bezeichnung "Precision timer NE 555" bekannt, dessen Zeitkonstante durch eine von außen zuschaltbare Kapazität sowie wenigstens einen ohmschen Widerstand festlegbar ist. Damit lassen sich Zeitglieder mit Zeiten von Mikrosekunden bis Stunden realisieren, weiterhin stabile oder monostabile Operationen durchführen. Bei Anwendungen in Serienfertigungen muß man bei Einsatz dieses Präzisionstimers aber den Nachteil in Kauf nehmen, einen erhöhten und damit kostenungünstigen Schaltungsaufwand zu haben. So ist man bei Serienanwendungen bestrebt, die zeitbestimmenden Teile ebenfalls in einer integrierten elektrischen Schaltungsanordnung unterzubringen. Problematisch ist dieses je-

...

doch insbesondere bei gewünschten großen Zeitkonstanten, die entsprechend hohe Kapazitäten erfordern. Bei der Herstellung einer integrierten elektrischen Schaltungsanordnung muß jedoch größtes Augenmerk auf den Flächenverbrauch gerichtet werden, so daß sich der Integration größerer Kapazitäten daher schnell Grenzen setzen. Größere Widerstände, die ebenfalls die Zeitkonstante beeinflussen könnten, sind ebenfalls in integrierten Schaltungsanordnungen nur mit erhöhtem Aufwand realisierbar, insbesondere wenn eine hohe Genauigkeit und exakte Reproduzierbarkeit der Widerstandswerte gefordert sind.

Vorteile der Erfindung

Die erfindungsgemäße integrierte elektrische Schaltungsanordnung nach der Gattung des Hauptanspruches hat demgegenüber den Vorteil, daß die Kapazität in die elektrische Schaltungsanordnung integriert ist, was dadurch möglich ist, daß der Ladestrom der Kapazität direkt gesteuert wird. Diese direkte Steuerung des Ladestromes unter Umgehung eines ohmschen Widerstandes ermöglicht es, bei entsprechend geringen Strömen kleine Kapazitäten verwenden zu können.

Durch die Unteransprüche sind vorteilhafte Ausgestaltungen der Erfindung angegeben. Insbesondere ist es vorteilhaft, daß die Kapazität in einem Miller-Integrator integriert wird, d.h. bei einer Festlegung des Kollektor-Emitter-Stromes eines Transistors wird die Kapazität durch den Basisstrom geladen, der um den Stromverstärkungsfaktor des Transistors geringer ist. Dabei ist von großem Vorteil, daß die Stromverstärkung eines Transistors weitgehend temperaturunabhängig ist. Wird die Kapazität durch eine stromgesteuerte Stromquelle, einen sogenannten Stromspiegel geladen, so kann

...

der Stromverstärkungsfaktor oder Spiegelfaktor, der zur
Verringerung des Ladestroms der Kapazität benutzt wird,
definiert eingestellt werden. Der Spiegelfaktor ist sehr
exakt einstellbar und reproduzierbar, da er sich proportional zu den Emitterflächer der verwendeten Transistoren verhält. Für Serienanwendungen kann der Ladestrom
von einer Konstantstromquelle gesteuert werden, es ist
aber auch vorteilhaft, die Steuerbarkeit des Ladestromes
soweit auszunutzen, daß etwa ein Schaltvorgang ermöglicht
wird, der den Ladestrom ein- oder ausschaltet, bzw. eine
Entladung der Kapazität ermöglicht. Eine Steuerung des
Ladestromes durch eine von außen auf die integrierte
elektrische Schaltungsanordnung einwirkende Größe eröffnet vielseitige Anwendungen der erfindungsgemäßen Schaltungsanordnung, so ist etwa durch einen einzigen ohmschen Widerstand die Funktion des aus dem Stand der Technik bekannten Präzionstimers einstellbar. Bei Schaltung
der erfindungsgemäßen Schaltungsanordnung zu einem integrierten Multivibrator, der vorteilhaft durch Rückkoppelung der Kondensatorspannung auf den Eingang eines Differenzverstärkers durchgeführt wird, welcher den Ladestrom steuert, lassen sich vielfach anwendbare Taktgeneratoren leicht herstellen. Der Ladestrom kann so temperaturabhängig dimensioniert werden, daß vorgegebene Temperaturkoeffizienten der Frequenz erreicht werden. Ein
solcher Multivibrator kann als Temperatursensor eingesetzt werden.


Zeichnung


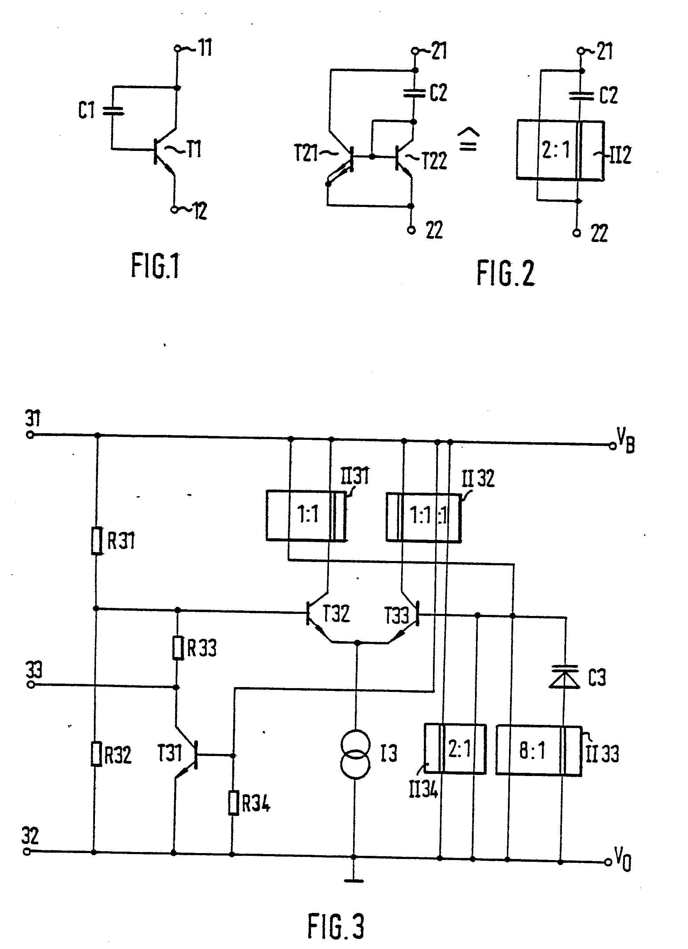

Ein Ausführungsbeispiel der Erfindung ist in der Zeichnung dargestellt und in der nachfolgenden Beschreibung
näher erläutert. Figur 1 und Figur 2 zeigen dabei zur
Verdeutlichung mögliche Anordnungen von Kapazitäten in-

...

nerhalb einer integrierten elektrischen Schaltungsanordnung; Figur 3 zeigt ein Ausführungsbeispiel einer erfindungsgemäßen Schaltungsanordnung, die zur Festlegung von
Zeiten eines Multivibrators dient.

Beschreibung des Ausführungsbeispieles

Die Figur 1 zeigt einen Transistor T1, dessen Kollektor
an eine Klemme 11 und dessen Emitter an eine Klemme 12
gelegt ist. Zwischen Kollektor und Basis des Transistors
T1 ist eine Kapazität C1 geschaltet. Wird nun der Transistor T1 mit einem konstanten Strom beaufschlagt, d.h.
an die Klemme 11 wird etwa eine Konstantstromquelle gelegt, deren Strom über den Kollektor zum Emitter fließt,
so wird die Kapazität C1 mit einem Strom geladen, der um
den Stromverstärkungsfaktor des Transistors T1 niedriger
ist. Der Stromverstärkungsfaktor eines bipolaren Transistors liegt etwa in der Größenordnung $10^2$, so daß hierdurch um den gleichen Faktor längere Ladezeiten der Kapazität erreicht werden können. Diese als Miller-Integrator bezeichnete Anordnung ist gut monolitisch integrierbar.

In Figur 2 ist eine Kapazität C2 gezeigt, die einerseits
an eine Klemme 21 und andererseits über die Kollektor-
Emitter-Strecke eines Transistors T22 an eine Klemme 22
gelegt ist. Die Klemmen 21, 22 der Figur 2 entsprechen
insoweit den Klemmen 11, 12 der Figur 1. Zwischen diese
Klemmen 21, 22 ist weiterhin die Kollektor-Emitter-Strecke
eines Transistors 21 geschaltet, dessen Basis mit dem
Kollektor und der Basis des Transistors 22 verbunden
ist. Der Transistors 22 stellt also einen als Diode geschalteten Eingangstransistor, der Transistor T21 einen
Ausgangstransistor dar. Weiterhin besitzt der Transistor
21 Doppelemitter, die jedoch miteinander kurzgeschlossen
sind.

...

Die Transistoranordnung der Figur 2 stellt eine sogenannte stromgesteuerte Stromquelle, bzw. einen Stromspiegel dar, wie sie etwa aus der Druckschrift "Philips Technische Rundschau", 32. Jahrgang, 1971/72, Nr. 1, Seiten 1 bis 12, bekannt sind. Das Verhältnis der Ströme im Transistor 21 zu den Strömen im Transistor 22 ist dabei durch die Anzahl der Emitter, bzw. durch deren Flächen in monolitisch integrierter Technik festgelegt. Sind wie in Figur 2 die Emitter der Transistoren an sich gleich, so ist der Stromverstärkungsfaktor bzw. der Spiegelfaktor 2 : 1, da der Transistor 21 zwei Emitter besitzt. Wird an die Klemme 21 eine Stromquelle angeschlossen, die dem Stromspiegel einen Strom einprägt, so verteilen sich die Ströme im Stromspiegel im Verhältnis zum Spiegelfaktor. Damit läßt sich daurch eine Flächendimensionierung eine exaktreproduzierbare Stromsteuerung des Ladestromes der Kapazität 2 erreichen. In Figur 2 ist auf der rechten Seite ein vereinfachtes Symbol eines Stromspiegels II2 dargestellt, das der Darstellung auf der linken Seite der Figur 2 entspricht. Ein solches Symbol ist etwa aus der Druckschrift "Funkschau", Heft 23/1983 bekannt. Eine derartige Anordnung nach Figur 2 ist ebenfalls einfach integrierbar.

Mit Hilfe einer Heruntersteuerung des Ladestroms der Kapazität C1 bzw. der Kapazität C2 gemäß den Figuren 1 bzw. 2 lassen sich um den entsprechenden Stromverstärkungsfaktor virtuell größere Kapazitäten herstellen. D.h., die elektrischen Verhältnisse an den Klemmen 11, 12 bei Strombetrieb verhalten sich so, als wenn eine einzige große Kapazität zwischengeschaltet wäre. Mit einer derartig virtuell vergrößerten Kapazität lassen sich demnach in integrierter Technik auch Zeitfunktionen realisieren, wie sie bisher nur durch extern an die integrierte elektrische Schaltung angeschlossene Kapazitäten realisiert werden konnten.

...

Figur 3 zeigt ein ausführlicheres Anwendungsbeispiel
eines integrierten Zeitgliedes mit einer ladestromgesteuerten Kapazität, einen vollständig integrierten
Multivibrator, auch Taktgeber genannt.

In Figur 3 ist an eine Klemme 31 eine Betriebsspannung
$V_B$ und an eine Klemme 32 eine Bezugsspannung $V_0$ gelegt,
zwischen die der Multivibrator geschaltet ist. Zentrale Anordnung des Multivibrators ist ein Differenzverstärker, der aus einem Transistor T32 und einem Transistor T33 besteht. Diese beide Transistoren sind in bekannter Weise mit den Emittern verbunden und über eine
Stromquelle I3 an die Bezugsspannung $V_0$ gelegt. Der Kollektor des Transistors T32 führt an die Steuerstrecke
eines Stromspiegels II31, der Kollektor des Transistors
T33 an eine Steuerstrecke eines Stromspiegels II32, der
zwei Ausgangsstrecken besitzt. Beide Stromspiegel sind
an die Betriebsspannung $V_B$ gelegt. Eine solche Anordnung
ist an sich aus dem Stand der Technik bekannt und zur
Vereinfachung der Darstellung daher nicht weiter erläutert.

Zwischen die Basis des Transistors T33 und die Klemme 32
ist eine Stromspiegelanordnung mit einem Stromspiegel
II33 und einer Kapazität C3, wie in Figur 2 rechte Seite,
geschaltet. Der Spiegelfaktor ist 1 : 8. Die Kapazität
C3 ist in integrierter Technik als ein gesperrter PN-
Übergang realisiert, stellt also eine Kapazitätdiode dar.
Der Strom für diese Anordnung wird dabei von der Ausgangsstrecke des Stromspiegels II31 geliefert, die ebenfalls
mit der Basis des Transistors T33 verbunden ist.

Die Basis des Transistors T32 ist an einen Spannungsteiler, bestehend aus einem Widerstand R31 und einem Wider-

...

stand R32 gelegt, die zwischen die Klemmen 31, 32 geschaltet sind. Damit ist die Basis des Transistors T32,
also ein Eingang des Differenzverstärkers, auf ein festes Bezugspotential gelegt, solange ein Transistor T31
geschlossen ist, dessen Kollektor-Emitter-Strecke über
einen Widerstand R33 an die Klemme 32 führt. Dabei ist
eine Ausgangsklemme 33 zwischen den Kollektor des Transistors T31 und den Widerstand R33 geschaltet. Die Basis-Emitter-Strecke des Transistors T31 ist einem Widerstand R34 parallel geschaltet. Der Basisstrom wird von
einer Ausgangsstrecke des Stromspiegels II32 geliefert.

Sei nun zu Beginn die Kapazität C3 ungeladen, und der
Spannung an der Basis des Transistors T32 des Differenzverstärkers durch den Spannungsteiler R31, R32 festgelegt. Die Basis des Transistors T33 des Differenzverstärkers ist dann direkt an die unungeladene Kapazität
C3 gelegt. Damit fließt der gesamte Strom der Stromquelle I3 über den Transistor T32, d.h. der Stromspiegel II31
liefert einen gleichgroßen Strom an den Stromspiegel
II33, d.h. ein um den Spiegelfaktor 8 geringerer Strom
lädt linear die Kapazität C3. Erreicht nun die Spannung
an der Kapazität C3 diejenige Spannung, die der Teilerspannung des Spannungsteilers R31, R32 entspricht, so
chaltet der Transistor T33 durch, d.h. die Stromaufteilung am und Differenzverstärker wechselt. Damit wird
nun der Stromspiegel II32 betrieben, dessen Ausgangsstrom über den Widerstand R34 den Transistor T31 leitend
schaltet. Damit wird das Teilerverhältnis an der Basis
des Transistors T32 des Differenzverstärkers um den Einfluß des Widerstandes R33 herabgesetzt, so daß sich das
**Potential an der Basis des Transistors T33** auf einem höheren Potential befindet. Damit ist eine vollständige
Übernahme des Stromes I3 durch den Transistor T33 gege-

...

ben. Die Funktionsweise dieser mitgekoppelten Stromumschaltung im Differenzverstärker ist die eines Schmitt-
Triggers.

Ein weiterer Stromspiegel II34 dient nun dazu, abhängig
vom Ausgangsstrom des Stromspiegels I32 die Kapazität C3
zu entladen. Dazu ist er mit seiner Steuerstrecke zwischen die die zweite Ausgangsstrecke des Stromspiegels
II32 und die Klemme 32 geschaltet. Seine Ausgangsstrecke
verbindet die Basis des Transistors T33 mit der Klemme
32. Der Entladevorgang geht solange, bis die Basisspannung am Transistor T33 gleich der an der Basis des Transistors T32 wird, was wiederum eine Stromumschaltung im
Differenzverstärker bewirkt, wodurch der Transistor T31
wieder hochohmig wird. Durch dieses Umschalten, dessen
Frequenz durch das Teilerverhältnis der Widerstände R31,
R32, R33, den Strom I3, die Kapazität C3 sowie die Spiegelfaktoren festgelegt ist, ergibt sich an der Kapazität
C3 eine periodische Dreiecksspannung, am Ausgang 33 am
Kollektor des Transistors T31 demgemäß eine Rechteckspannung.

R. 19474
18.6.1984 Ko/Pi

- 1 -

0166161

ROBERT BOSCH GMBH, 7000 STUTTGART 1


Ansprüche

1. Integrierte elektrische Schaltungsanordnung zur Festlegung von Zeiten mit einer Kapazität zur Festlegung einer Zeitkonstanten, dadurch gekennzeichnet, daß die Kapazität in die elektrische Schaltung integriert ist, und daß die Zeitkonstante durch einen steuerbaren Ladestrom der Kapazität gesteuert wird.

2. Schaltungsanordnung nach Anspruch 1, dadurch gekennzeichnet, daß die Kapazität durch einen Miller-Integrator geladen wird.

3. Schaltungsanordnung nach Anspruch 1 oder 2, dadurch gekennzeichnet, daß die Kapazität durch eine stromgesteuerte Stromquelle geladen wird.

4. Schaltungsanordnung nach einem der Ansprüche 1 bis 2, dadurch gekennzeichnet, daß der Ladestrom von einer Konstantstromquelle gesteuert wird.

5. Schaltungsanordnung nach einem der Ansprüche 1 bis 3, dadurch gekennzeichnet, daß der Ladestrom in Abhängigkeit von einer von außen auf die Schaltungsanordnung einwirkenden Größe gesteuert wird, vorzugsweise geschaltet wird.

...

6. Schaltungsanordnung nach Anspruch 5, dadurch gekennzeichnet, daß der Ladestrom in Abhängigkeit von der Temperatur gesteuert wird.

7. Schaltungsanordnung nach Anspruch 5, dadurch gekennzeichnet, daß der Ladestrom durch einen nichtintegrierten, von außen an die Schaltungsanordnung geschalteten ohmschen Widerstand gesteuert wird.

8. Schaltungsanordnung nach einem der vorhergehenden Ansprüche, dadurch gekennzeichnet, daß die Zeitkonstante zur Festlegung der Frequenz eines astabilen Multivibrators dient.

9. Schaltungsanordnung nach Anspruch 8 und Anspruch 6, dadurch gekennzeichnet, daß die Schaltungsanordnung als Temperatursensor eine temperaturabhängige Frequenz besitzt.

10. Schaltungsanordnung nach Anspruch 8 oder Anspruch 9, 7, dadurch gekennzeichnet, daß der Ladestrom in Abhängigkeit der Ausgangsspannung eines Differenzverstärkers gesteuert wird und daß die Eingangsspannung des Differenzverstärkers in Abhängigkeit der Spannung an der Kapazität geschaltet wird, so daß sich die Flußrichtung des Ladestroms umkehrt.

FIG.1

FIG.2

FIG.3

0166161

19 474